# EUROPÄISCHE PATENTSCHRIFT

(11) **EP 2 015 350 B1**
(45) Veröffentlichungstag und Bekanntmachung des Hinweises auf die Patenterteilung: **02.05.2012**
(21) Anmeldenummer: 08009987.2
(22) Anmeldetag: 31.05.2008
(51) Int. Cl.: H01L 21/265, H01L 21/329, H01L 29/36, H01L 29/861

(54) **Halbleiterbauelement mit Pufferschicht**
Semiconductor component with buffer layer
Composant semi-conducteur doté d'une couche-tampon

(30) Priorität: 20.06.2007 DE 102007028316
(43) Veröffentlichungstag der Anmeldung: 14.01.2009
(73) Patentinhaber: SEMIKRON Elektronik GmbH & Co. KG, 90431 Nürnberg (DE)
(72) Erfinder: König, Bernhard, Dr., 90765 Fürth (DE)

(56) Entgegenhaltungen:
- JP-A- 2000 223 720
- US-A1- 2007 108 558
- NEMOTO M ET AL: "MBBL diode: a novel soft recovery diode" POWER SEMICONDUCTOR DEVICES AND ICS, 2004. PROCEEDINGS. ISPSD '04. THE 16TH INTERNATIONAL SYMPOSIUM ON KITAKYUSHU INT. CONF. CTR, JAPAN MAY 24-27, 2004, PISCATAWAY, NJ, USA,IEEE, 24. Mai 2004 (2004-05-24), Seiten 433-436, XP010723442 ISBN: 978-4-88686-060-6
- RAHIMO M T ET AL: "A review on fast power diode development and modern novel structures" 19960621, 21. Juni 1996 (1996-06-21), Seiten 2/1-212, XP006510930

## Beschreibung

Die Erfindung beschreibt ein Halbleiterbauelement mit mindestens einem pn-Übergang, vorzugsweise eine Diode für Anwendungen der Leistungsklasse. Derartige Dioden finden beispielhaft in der Kombination mit Leistungsschaltern, speziell Leistungstransistoren, als sog. Freilaufdioden Anwendung.

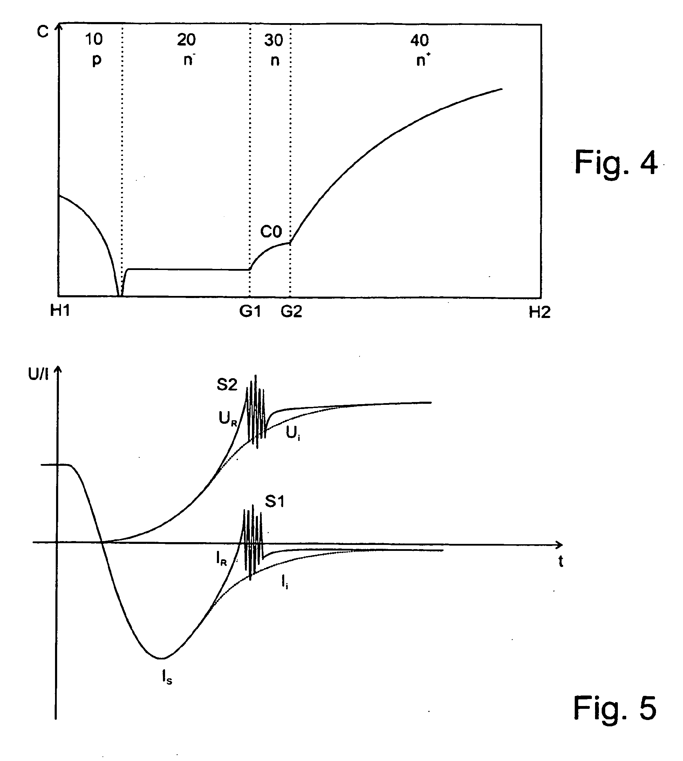

Grundsätzlich ist es beispielhaft aus der EP 1 096 576 A1 bekannt derartige Dioden in einer Schichtfolge mit einer ersten Zone erster Dotierung und weiteren Zonen zweiter Dotierung auszubilden. Unter Dotierung wird hierbei die Anordnung von Dotierstoffatomen, von Donatoren oder Akzeptoren, in einer Volumeneinheit verstanden, somit entsteht dort eine Konzentration pro Volumeneinheit. Hierbei entspricht es dem Stand der Technik, dass in den weiteren Zonen die Konzentration der zweiten Dotierung ausgehend von der ersten Zone stetig oder unstetig steigt. Es ist bekannt, dass in einzelnen dieser weiteren Zonen die Konzentration der Dotierung konstant ausgebildet ist, ebenso kann die Konzentration der Dotierung in einer oder mehreren Zonen einer Exponentialfunktion gehorchend ansteigen. Wesentlich ist jedoch, dass die Konzentration der Dotierung einen grundsätzlichen Verlauf gemäß Fig. 4 aufweist.

Fig. 4 zeigt beispielhaft das Konzentrationsprofil der Dotierung einer Leistungsdiode nach dem Stand der Technik. Dargestellt ist hier eine erste Hauptfläche (H1), an die sich eine erste, hier eine p- dotierte, Zone (10) anschließt. Im Anschluss folgt die n⁻-dotierte, zweite Zone (20), die vorzugsweise die konstante Grundkonzentration der Dotierung des Basismaterials, hier eines Silziumwafers, aufweist. An diese zweite Zone (20) schließt sich eine erste Grenzfläche (G1) und eine dritte n -dotierte Zone (30) an, die die Aufgabe einer Pufferschicht erfüllt. Als letzte, vierte, Zone (40) der Schichtfolge folgt mit der Grenzfläche (G2) hier eine n⁺-dotierte Zone und im Anschluss daran die zweite Hauptfläche (H2) des Halbleiterbauelements. Notwendige Metallisierung der Hauptflächen (H1, H2) zu Kontaktzwecken werden hier nicht weiter beschrieben.

Gemäß dem Stand der Technik sind die dritte (30) und vierte Zone (40) mittels Diffusionsverfahren aus Richtung der zweiten Hauptfläche (H2) entstanden. Hierdurch ergibt sich auch das für Diffusionsverfahren typische Profil dieser Dotierungen. Die p-Dotierung der ersten Zone (10) erfolgt gemäß dem Stand der Technik mittels Diffusionsverfahren aus Richtung der ersten Hauptfläche (H1).

Wie oben genannt finden derartige Leistungsdioden als Freilaufdioden in antiparalleler Schaltung mit Leistungstransistoren Anwendung. Fig. 5 zeigt den Strom- und Spannungsverlauf über der Diode im Falle des Einschaltens eines antiparallel geschalteten Leistungstransistors, wobei die Diode vom Durchlass in den Sperrzustand überführt wird. Im Idealfall steigt hierbei die über der Diode abfallende Spannung (Uᵢ) auf annähernd den Wert der Spannungsquelle an. Gleichzeitig sinkt der Strom (Iᵢ) durch die Diode auf Null. Im weiteren Verlauf wird der Stromfluss negativ, bzw. ändert seine Richtung, da hier der pn- Übergang von Ladungsträgern frei geräumt wird. Im Weiteren klingt der Strom auf den Sperrstrom der Diode ab.

Im realen Betrieb unterscheiden sich der Strom- (I_{R}) und Spannungsverlauf (U_{R}) auf Grund parasitärer Induktivitäten und einer nicht idealen Bauteilcharakteristik der Diode und des Leistungstransistors. Durch eine schnell zeitliche Änderung des Stroms nach der Rückstromspitze (Iₛ) werden Überspannungen und daraus resultierende Schwingungen im realen Spannungs- (U_{R}) und somit auch im Stromverlauf (I_{R}) induziert. Der physikalische Effekt hierbei ist die schnelle Feldausbreitung des elektrischen Feldes in der Diode. Hierdurch werden die positiven und negativen Ladungsträger sehr schnell entfernt, wodurch ein Abriss des Stroms erfolgt. Bekannte Pufferschichten (30, vgl. Fig. 4) bilden hier eine Reserve an Ladungsträgern um die Geschwindigkeit der Entfernung zu reduzieren und somit den Abriss des Stroms zu verlangsamen.

Die genannten Schwingungen (S1, S2) begrenzen einerseits die maximal mögliche Schaltgeschwindigkeit der Anordnung aus Diode und Leistungstransistor, was eine Beschränkung der Funktionalität hieraus aufgebauter Stromrichter bedeutet.

Andererseits können zu hohe Amplituden der Schwingungen (S1, S2) die Diode selbst zerstören. Eine möglichst geringe Schwingungsneigung und ebenso eine kleine Amplitude der Schwingung (S1, S2) sind daher steter Gegenstand der Forschung.

Näheres zum Stand der Technik offenbart JP 2000-223720. Zwecks einer Entspannung des rapiden Stromabfalls am Ende der Gleichgewichtswiederherstellung bei der Spannungsumkehr und zum Zwecke einer Vermeidung von Spannungsspitzen wird dort ein Halbleiterelement aufgezeigt, bei dem eine p Anodenschicht und eine n+ Kathodenschicht, die an jeweiligen Enden eines aus einem niedrig dotierten n-Halbleiter gebildeten Substrats angeordnet sind. Eine i-Schicht ist zwischen der p Anodenschicht und der n+ Kathodenschicht gebildet. Eine n-dotierte Schicht mit einer niedrigeren Dotierung als die n+ Kathodenschicht wird zwischen der i-Schicht und der n+ Kathodenschicht gebildet, wobei die n-dotierte Schicht mit einer deutlich kürzeren Breite als die Breite der i-Schicht gebildet wird.

Der Erfindung liegt somit die Aufgabe zugrunde ein Halbleiterbauelement mit mindestens einem pn- Übergang und einer Pufferschicht derart weiterzubilden, dass die Schalteigenschaften in Schaltungsanordnungen mit Leistungsschaltern verbessert werden.

Diese Aufgabe wird erfindungsgemäß gelöst, durch den Gegenstand mit den Merkmalen des Anspruchs 1 sowie durch ein Verfahren gemäß Anspruch 5. Bevorzugte Ausführungsformen sind in den Unteransprüchen beschrieben.

Ausgangspunkt der Erfindung ist ein Halbleiterbauelement mit mindestens einem Wechsel einer ersten zu einer zweiten Dotierung, einem pn- Übergang. Dieses Halbleiterbauelement weist somit eine Schichtfolge einer, einer ersten Hauptfläche zugewandten, ersten Zone mit erster Dotierung und einem anschließenden Bereich mit zweiter Dotierung auf. Dieser Bereich zweiter Dotierung ist seinerseits durch mindestens drei Zonen unterschiedlicher Konzentration der Dotierung gebildet. Im direkten Anschluss an die erste Zone erster Dotierung folgt eine zweite Zone mit geringer und homogener Konzentration einer zweiten Dotierung. Hieran schließt sich eine Pufferschicht, die dritte Zone, ebenfalls zweiter Dotierung an. Den Abschluss bildet eine, einer zweiten Hauptfläche zugewandten, vierte Zone mit hoher Konzentration zweiter Dotierung.

Die Pufferschicht ist derart ausgebildet, dass die Konzentration der zweiten Dotierung der Pufferschicht an deren erster Grenzfläche zur zweiten Zone höher ist als an der zweiten Grenzfläche zur vierten Zone. Durch diese Ausbildung der Pufferschicht ist, da im Bereich der hohen Konzentration die Ausbreitung des elektrischen Feldes behindert wird, im Bereich niedriger Konzentration eine Reserve an Ladungsträgern vorhanden ist.

Die Konzentration der Pufferschicht fällt linear, exponentiell oder pulsierend ab.

Es ist besonders bevorzugt, wenn die erste Zone p- dotiert ist, die zweite Zone n⁻-dotiert ist, die vierte Zone n⁺-dotiert ist und die dritte Zone eine maximale Konzentration einer n- Dotierung aufweist, die größer der maximalen Konzentration der zweiten Zone und kleiner der maximalen Konzentration der vierten Zone ist.

Die Pufferschicht, die dritte Zone, wird mittels Ionenimplantation erzeugt. Ein erfindungsgemäßes Verfahren führt dann zu einer pulsierenden Abnahme der Konzentration der Dotierung von der ersten Grenzfläche der Pufferschicht zur zweiten Grenzfläche der Pufferschicht. Mittels der Ionenimplantation werden hierbei Dotieratome gestuft in verschiedenen Tiefen und mit zunehmender Tiefe, vorzugsweise von der ersten Hauptfläche aus, mit abnehmender Konzentration eingebracht. Somit ergibt sich die pulsierende Abnahme der Konzentration innerhalb der Pufferschicht.

Besonders bevorzugte Weiterbildungen dieses Halbleiterbauelements sind in der jeweiligen Beschreibung der Ausführungsbeispiele genannt. Die erfinderische Lösung wird zudem an Hand der Ausführungsbeispiele und der Fig. 1 bis 3 weiter erläutert.

Fig. 1 zeigt ein Dotierungsprofil eines ersten erfindungsgemäßen Halbleiterbauelements, hier einer Leistungsdiode.

Fig. 2 zeigt den Verlauf des elektrischen Feldes während der Rückstrom durch eine Leistungsdiode, gemäß Fig. 1, abklingt.

Fig. 3 zeigt ein Dotierungsprofil eines zweiten erfindungsgemäßen Halbleiterbauelements.

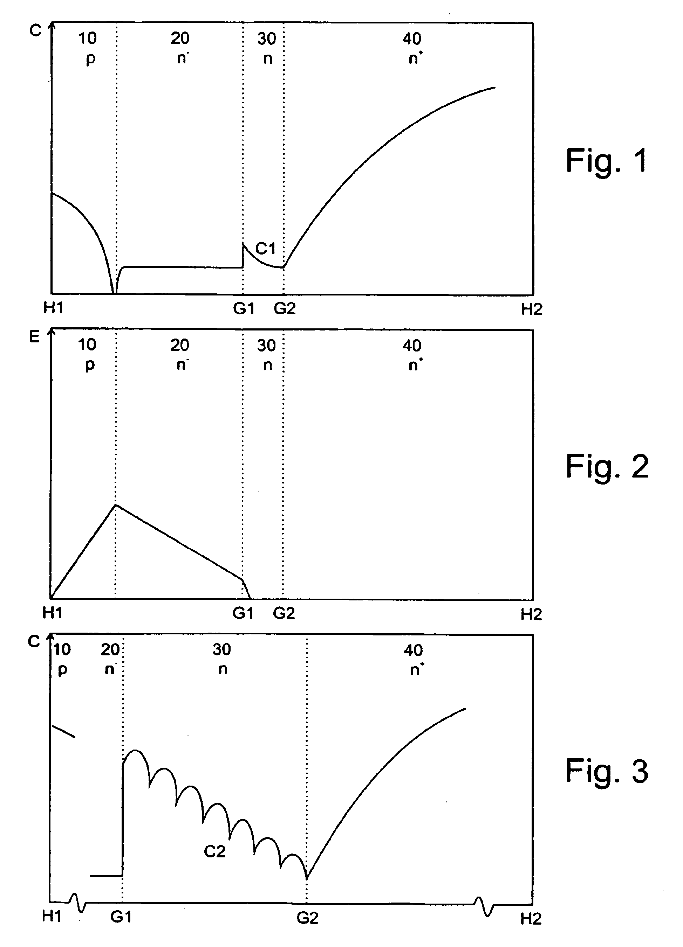

Fig. 1 zeigt ein Dotierungsprofil eines ersten erfindungsgemäßen Halbleiterbauelements, hier einer Leistungsdiode. Dargestellt sind die beiden Hauptflächen (H1, H2) der Diode, wobei auf die Darstellung einer möglicherweise notwendigen Kontaktmetallisierung auf diesen Hauptflächen (H1, H2) verzichtet wurde.

An die erste Hauptfläche (H1) schließt sich eine p- dotierte erste Zone (10) an, deren Konzentration der Dotierung von 10²⁰ auf 10¹³ absinkt. Der Wechsel zur nächsten Zone bildet den pn- Übergang der Diode. Diese folgende zweite Zone (20) weist eine homogene n-Dotierung mit einer Konzentration im Bereich von 10¹³ bis 10¹⁵ auf. Vorzugsweise entspricht diese Konzentration der Grunddotierung des Wafers. Auf die zweite (20) folgt eine dritte Zone (30), die sog. Pufferschicht, mit einer Dotierung, deren Konzentration (C1) in Richtung der zweiten Hauptfläche (H2) stetig geringer wird im Gegensatz zum Stand der Technik (vgl. CO in Fig. 4). An der Grenzfläche (G1) zur zweiten Zone (20) weist die Dotierung eine Konzentration von 10¹³ bis 10¹⁷ auf. Dieser Wert sinkt zum Ende der Pufferschicht (30), hier auf den Wert der Grunddotierung, ab. Dieser Abfall der Konzentration (C1) kann linear oder exponentiell ausgeprägt sein, wobei der lineare Abfall hierbei bevorzugt ist.

Im Anschluss an die Pufferschicht (30) folgt die vierte, hier die letzte, Zone (40) zweiter Dotierung, wobei deren Konzentration exponentiell von der Grunddotierung stark ansteigt auf einen Wert in der Größenordnung von 10²⁰.

Fig. 2 zeigt den Verlauf des elektrischen Feldes während der Rückstrom durch eine Leistungsdiode gemäß Fig. 1 abklingt, dies ist beispielhaft zum Zeitpunkt (T1, vgl. Fig. 5) gegeben. Der Feldverlauf in der ersten (10) und zweiten (20) Zone entspricht bis Nahe an die Pufferschicht (30) dem Stand der Technik. Durch die erfindungsgemäße Ausbildung der Pufferschicht (30) wird die Ausbreitung des elektrischen Feldes von der zweiten (20) zur vierten Zone (40) verhindert. Es entsteht eine gewisse Reserve an positiven Ladungsträgern. Diese minimiert oder verhindert den Abriss des Rückstroms und damit die Ausbildung von Schwingungen (S1, S2; vgl. Fig. 5)

Fig. 3 zeigt ein Dotierungsprofil eines zweiten erfindungsgemäßen Halbleiterbauelements. Hierbei sind die erste (10), zweite (20) und vierte (40) Zone analog demjenigen unter Fig. 1 beschriebenen Halbleiterbauelement ausgebildet.

Die Pufferschicht (30) weist an ihrer ersten Grenzfläche (G1) zur zweiten Zone (20) eine höhere Konzentration der Dotierung auf als an ihrer zweiten Grenzfläche (G2) zur vierten Zone (40). Die Konzentration (C2) fällt erfindungsgemäß von dieser ersten (G1) zur zweiten (G2) Grenzfläche nicht linear sondern pulsierend ab. Dieser Verlauf entsteht durch den Herstellungsprozess gemäß eines erfindungsgemäßen Verfahrens.

Hierbei wird die Pufferschicht (30) von Richtung der ersten Hauptfläche (H1) mittels Ionenimplantation dotiert. Dargestellt ist hier das Ergebnis von sieben Implantationsschritten, wobei dies nur der Erläuterung dient. Es ist bevorzugt hierbei zwischen 2 und 10 Schritten vorzusehen. Durch jeden Implantationsschritt werden in einer definierten Tiefe des Wafers Dotieratome eingebracht. Die Tiefenverteilung der Dotieratome ist physikalisch bedingt durch eine Verteilungsfunktion gekennzeichnet.

Durch eine Mehrzahl dieser Implantationsschritte mit unterschiedlicher Eindringtiefe wird das charakteristische pulsierende Profil (C2) erzeugt. Durch Reduktion der Anzahl an implantierten Dotieratromen nimmt die Konzentration wie dargestellt von der ersten (G1) zur zweiten Grenzfläche (G2) der Pufferschicht (30) pulsierend ab.

## Patentansprüche

1. Halbleiterbauelement mit mindestens einem Wechsel einer ersten zu einer zweiten Dotierung, einem pn- Übergang, mit einer Schichtfolge einer, einer ersten Hauptfläche (H1) zugewandten, ersten Zone (10) mit erster Dotierung, einer anschließenden zweiten Zone (20) mit geringer, homogener Konzentration einer zweiten Dotierung, einer anschließenden Pufferschicht, der dritten Zone (30), zweiter Dotierung und einer anschließenden, einer zweiten Hauptfläche (H2) zugewandten, vierten Zone (40) mit hoher Konzentration der zweiten Dotierung, wobei
die Konzentration der zweiten Dotierung der Pufferschicht (30) an deren ersten Grenzfläche (G1) zur zweiten Zone (20) höher ist als an der zweiten Grenzfläche (G2) zur vierten Zone (40), und
die Konzentration (C1, C2) der Pufferschicht (30) von ihrer ersten Grenzfläche (G1) zu ihrer zweiten Grenzfläche (G2) exponentiell, linear oder pulsierend abfällt, wobei die pulsierend abfallende Konzentration lokale Maxima und Minima aufweist deren Werte stetig abnehmen.

2. Halbleiterbauelement nach Anspruch 1,
wobei die erste Zone (10) p- dotiert ist, die zweite Zone (20) n⁻ -dotiert ist, die vierte Zone (40) n⁺ -dotiert ist und die Pufferschicht, die dritte Zone (30), eine Konzentration einer n- Dotierung aufweist, die größer der maximalen Konzentration der zweiten Zone (20) und kleiner der maximalen Konzentration der vierten Zone (40) ist.

3. Halbleiterbauelement nach Anspruch 2,
wobei die n⁻ -dotierte zweite Zone (20) eine maximale Konzentration von 10¹³ bis 10¹⁵ aufweist, die dritte Zone (30), die Pufferschicht, eine maximale Konzentration von 10¹⁷ aufweist und die n⁺ -dotierte vierte Zone (40) eine maximale Konzentration von der Größenordnung 10²⁰ aufweist.

4. Verfahren zur Herstellung eines Halbleiterbauelements nach Anspruch 1,
wobei die abfallende Konzentration der Pufferschicht (30) durch lonenimplantation erzeugt wird und wobei, im Falle einer pulsierend abfallende Konzentration diese
Implantationsschritten mit jeweils unterschiedlichen Eindringtiefen der Dotieratome erzeugt wird.

5. Verfahren nach Anspruch 4,
wobei die Ionenimplantation von der ersten Hauptfläche (H1) aus erfolgt.

## Claims

1. A semiconductor component with at least one changeover from a first to a second doping, a pn-transition, with a sequence of layers of a first zone (10), facing towards a first main surface (H1), with a first doping, a subsequent second zone (20) with a low homogeneous concentration of a second doping, a subsequent buffer layer, which is the third zone (30), with a second doping, and a subsequent, fourth zone (40), facing towards a second main surface (H2) with a high concentration of the second doping, wherein
the concentration of the second doping of the buffer layer (30) at its first interface (G1) with the second zone (20) is higher than at the second interface (G2) with the fourth zone (40), and
the concentration (C1, C2) of the buffer layer (30) falls from its first interface (G1) to its second interface (G2) exponentially, linearly or in an pulsating manner, wherein
the concentration falling in an pulsating manner has local maxima and minima whose values decrease steadily.

2. The semiconductor component in accordance with Claim 1, wherein
the first zone (10) is p-doped, the second zone (20) is n⁻-doped, the fourth zone (40) is n⁺-doped, and the buffer layer, the third zone (30), has a concentration of an n-doping that is greater than the maximum concentration of the second zone (20), and smaller than the maximum concentration of the fourth zone (40).

3. The semiconductor component in accordance with Claim 2, wherein
the n⁻-doped second zone (20) has a maximum concentration of 10¹³ to 10¹⁵, the third zone (30), the buffer layer, has a maximum concentration of 10¹⁷ , and the n⁺-doped fourth zone (40) has a maximum concentration of the order of 10²⁰.

4. A method for the manufacture of a semiconductor component in accordance with Claim 1, wherein
the falling concentration of the buffer layer (30) is generated by means of ion implantation, and wherein
in the case of a concentration that is falling in a pulsating manner, this is generated by means of a multiplicity of implantation steps, in each case with different penetration depths for the doping atoms.

5. The method in accordance with Claim 4, wherein
the ion implantation is undertaken starting from the first main surface (H1).

## Revendications

1. Composant à semi-conducteurs comprenant au moins une alternance d'un premier dopage et d'un second dopage, une transition pn, une succession de couches d'une première zone (10), associée à une première surface principale (H1), avec un premier dopage, une seconde zone (20) consécutive avec une faible concentration homogène d'un second dopage, une couche tampon consécutive, la troisième zone (30), le second dopage et une quatrième zone (40) consécutive, associée à une seconde surface principale (H2), avec une concentration élevée du second dopage,
la concentration du second dopage de la couche tampon (30) sur sa première surface limite (G1) par rapport à la seconde zone (20) étant supérieure à celle sur la seconde surface limite (G2) par rapport à la quatrième zone (40), et
la concentration (C1, C2) de la couche tampon (30) décroissant de façon exponentielle, linéaire ou pulsatoire depuis sa première surface limite (G1) vers sa seconde surface limite (G2), la concentration décroissant de façon pulsatoire présentant des maxima et minima locaux, dont les valeurs diminuent constamment.

2. Composant à semi-conducteurs selon la revendication 1,
la première zone (10) étant dopée en p, la seconde zone (20) dopée en n⁻, la quatrième zone (40) en n⁺ et la couche tampon, la troisième zone (30), présentant une concentration d'un dopage n, qui est supérieure à la concentration maximale de la seconde zone (20) et inférieure à la concentration maximale de la quatrième zone (40).

3. Composant à semi-conducteurs selon la revendication 2,
la seconde zone (20) dopée en n⁻ présentant une concentration maximale de 10¹³ jusqu'à 10¹⁵, la troisième zone (30), la couche tampon, présentant une concentration maximale de 10¹⁷ et la quatrième zone (40) dopée en n⁺ une concentration maximale de l'ordre de 10²⁰.

4. Procédé pour fabriquer un composant à semi-conducteurs selon la revendication 1, la concentration décroissante de la couche tampon (30) étant générée par implantation d'ions et, dans le cas d'une concentration décroissant de façon pulsatoire, celle-ci étant générée par une pluralité d'étapes d'implantation avec des profondeurs de pénétration respectivement différentes des atomes de dopage.

5. Procédé selon la revendication 4,
l'implantation d'ions s'effectuant à partir de la première surface principale (H1).
